Europäisches Patentamt

European Patent Office

Office européen des brevets

(11) Publication number: 0 398 521
A2

# EUROPEAN PATENT APPLICATION

(21) Application number: 90304438.6

(22) Date of filing: 25.04.90

(51) Int. Cl.⁵: G06F 11/20

(30) Priority: 12.05.89 JP 117282/89

(43) Date of publication of application:
22.11.90 Bulletin 90/47

(84) Designated Contracting States:
DE FR GB

(71) Applicant: International Business Machines
Corporation
Old Orchard Road
Armonk, N.Y. 10504(US)

(72) Inventor: Inazumi, Junnichi, 8 goh
Wakatahaitsu
7-9 Umegaoka, Midori-ku
Yokohama-shi, Kanagawa-ken(JP)
Inventor: Kobayashi, Shigetaka
5-7-44 Sakuradai
Isehara-shi, Kanagawa-ken(JP)
Inventor: Nakamoto, Junn
3-19-9 Tsurukawa
Machida-shi, Tokyo-to(JP)

(74) Representative: Harris, Ian Richard
IBM United Kingdom Limited Intellectual
Property Department Hursley Park
Winchester, Hants. SO21 2JN(GB)

(54) Memory system.

(57) A memory system wherein a plurality of memory
locations arranged in rows and columns are divided
into blocks, wherein each memory location is tested
in an initialisation procedure and wherein if the ca-
pacity of the available memory locations is less than
a predetermined capacity then the row and the col-
umn addresses are interchanged.

FIG. 1

## MEMORY SYSTEM

The invention relates to a memory system which has a memory accessed by row and column addresses and, more particularly, to a memory system of the block management type which prevents addressing of blocks containing error locations.

The capacity of semiconductor memories is rapidly increasing due to lowering chip manufacturing costs and increases in integration density. However, with the increases in integration density the failure rate of semiconductor memories has also risen. Consequently, in memory systems of the block management type having no error correcting function a memory test is usually conducted at start-up time or when switching the power on. Access is prevented to those blocks containing error locations.

For example, according to the invention disclosed in Japanese Published Unexamined Patent Application (PUPA) No. 51-25941, a check circuit having a self-diagnosing function is provided for each block of a memory, so as to successively shift the addresses, excluding the blocks in which errors have been detected. In this method, however, if a stationary failure takes place along an address line selected by a row address and a column address, errors will occur in all blocks linked to that address line, resulting in the entire memory being unusable.

According to Japanese PUPA No. 57-109198, in which a word is accessed from a plurality of memory blocks by addressing these blocks with the same row and column addresses, if two errors occur in the same word, one of the blocks in which the errors occur is addressed with the row and column addresses interchanged so that another location involving no error may be addressed. In this way a plurality of errors in the same word are converted into a single error to be correctable by Error Correcting (ECC) codes. This methoddeals with soft errors by effectively utilising temporarily any memory block containing an error; always dealing with stationary errors in this way, however, is not desirable because of prolonged processing time.

An interleave method is also sometimes used in which, by writing into the memory in the row direction and reading in the column direction to deal with the stationary burst error, the burst error in writing is converted into random errors in reading, thereby enabling error correction to be made with use of ECC codes or the like. However, while this method is effective for continuous data reading, it is not suitable for error correction of data which are randomly read out.

The problem may be summarised thus: if a memory system of block management type having no error correcting function is arranged in such a manner that it does not utilise any block containing a location where an error has been detected in the memory test at start-up then, in the event of a burst error occurring encompassing a plurality of blocks, such as address line failure, the capacity of usable blocks is reduced and may become insufficient to store the predetermined amount of information allocated to the memory.

Therefore, in accordance with the present invention there is provided a memory system comprising a memory having a plurality of locations, each of said locations being addressable by a row address signal and a column address signal, control means for managing access permission to a plurality of blocks within the memory, each block consisting of a plurality of the locations, the control means testing each location of the memory to identify blocks containing no error locations and to determine whether the capacity of the blocks containing no error locations is smaller than a predetermined capacity, means for interchanging the row address signal and the column address signal in response to determination of the capacity of the blocks containing no error locations being smaller than the predetermined capacity.

Since a burst error caused by a failure in any address line or its driver circuit often encompasses a plurality of blocks, the configuration of memory blocks is changed by interchanging the row and column addresses in response to the address switching signal which is generated if, in the memory test, the capacity of blocks without error is detected to be smaller than a predetermined capacity. With the column and row addresses switched the burst error will be concentrated along an address line in a single block, resulting in the capacity of usable blocks being increased.

This invention makes it possible to reduce the number of blocks which are inaccessible because they contain error locations, thereby increasing the usable memory space.

An embodiment of the invention will now be described with reference to the following figures wherein,

fig. 1 is a block diagram of a memory system according to an embodiment of the invention,

fig. 2 is a logic circuit diagram of a multiplexor in an embodiment of the invention,

fig. 3 is a logic circuit diagram of an address decoder in an embodiment of the invention,

fig. 4 is a diagram showing the distribution of memory addresses and memory blocks when the switching control signal is not provided,

fig. 5 is a diagram showing the distribution of the memory addresses and the memory blocks when the switching control signal is provided,

fig. 6 is a flowchart showing the operations of the controller when implementing the memory address control system of an embodiment of the invention.

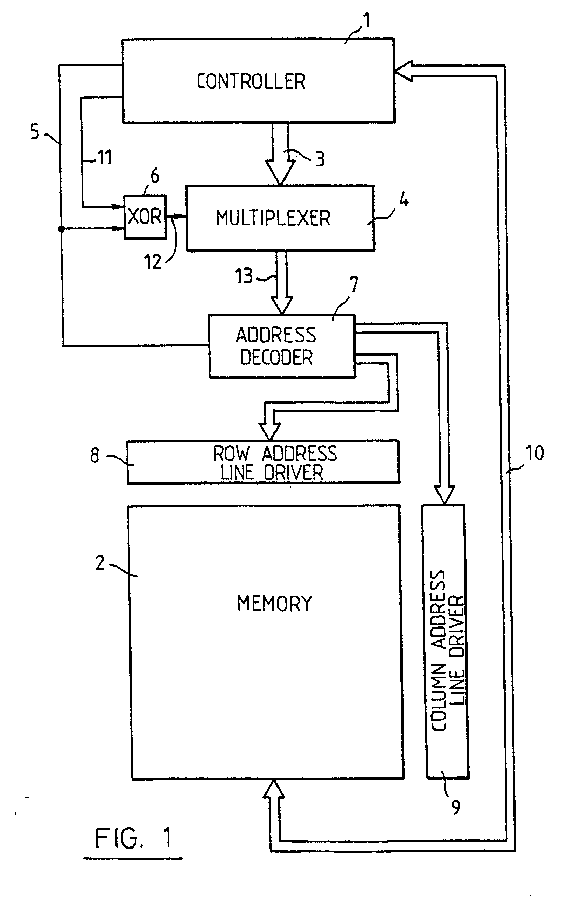

Fig. 1 is a schematic diagram representing a memory system according to the embodiment of the invention. A controller 1, under the control of a control program, feeds 20-bit address signals to a multiplexor 4 through an address line 3 for addressing a one megabyte memory 2. The multiplexor 4 selectively feeds the upper ten bits and the lower ten bits of the 20 bit address signals via the address line 13 to an address decoder 7 in response to a selection signal fed from the controller 1 through a control line 5 and an XOR circuit 6. The address decoder 7 feeds the upper ten bits and the lower ten bits of address signals to a row address line driver 8 and a column address line driver 9 in response to the selection signal from the controller 1. In this way the 20-bit address signals fed from the controller 1 are supplied to the row address line driver 8 and the column address line driver 9 as 10-bit row address signals and 10-bit column address signals under the control of the selection signal to be used for addressing arbitrary locations in the memory 2. Data to be written into the memory locations, accessed according to the address signals, are fed from the controller 1 through a data bus 10, while data read out from those locations are fed to the controller 1 through the data bus 10.

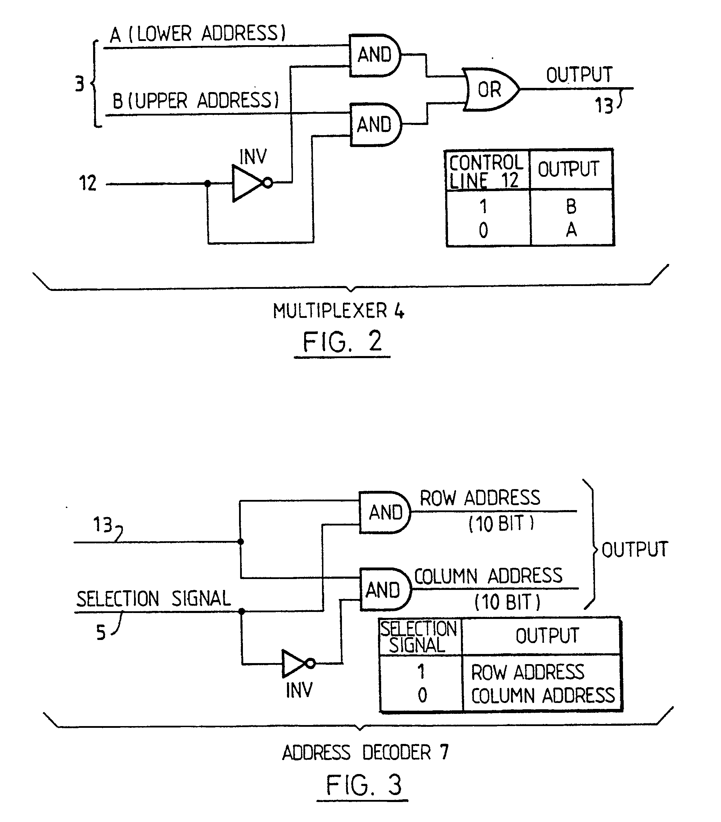

Fig. 2 shows a logic circuit diagram of the multiplexor 4 in fig. 1 and a truth table representing the relationship between the output signal and the selection signal on control line 12 after it has passed through the XOR circuit 6, and fig. 3 shows a logic circuit diagram of the address decoder 7 in fig. 1 and a truth table representing the relationship between the selection signal on control line 5 and the output signal.

The memory 2 is a dynamic RAM having a capacity of one megabyte, with each location so arranged as to store eight bits or one byte of data and arranged in 1024 rows x 1024 columns. This memory system comprises 16 blocks, each of which consists of 64 kilobytes or 64 columns of locations, and managed as a block. It is so managed that all locations in each block containing any error location may be excluded from the addressing logic, so that they cannot be addressed.

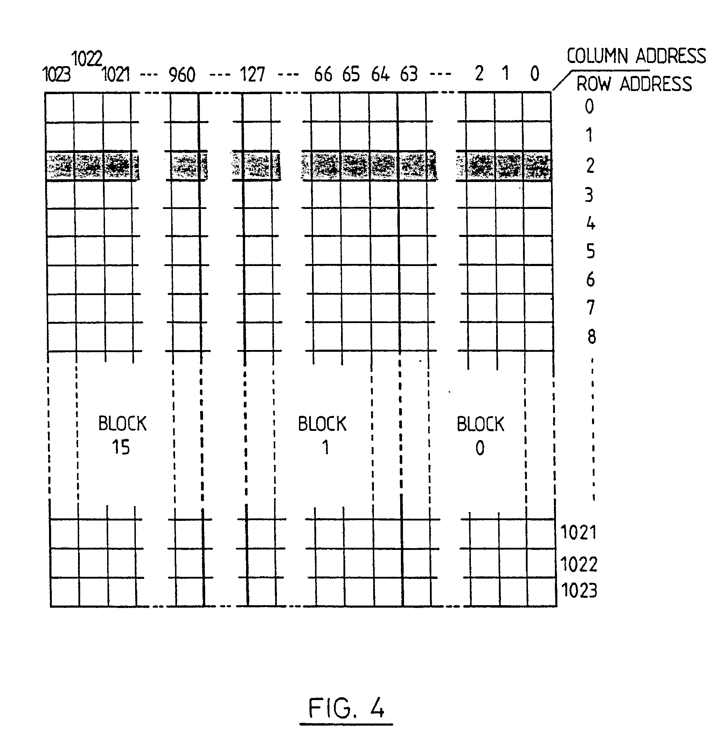

Assuming that one of address lines in such a memory, for example, the address line for addressing the row 2 has failed, as shown in fig 4. All locations linked to this row 2 (0, 2), (1, 2), (2, 2), (3, 2) ... (1023, 2) are regarded as error locations. Because these locations are distributed in all memory blocks, all blocks should therefore be taken to be error blocks. In this way, failure on one address causes the entire memory to be processed as error memory and none of the memory locations may be accessed.

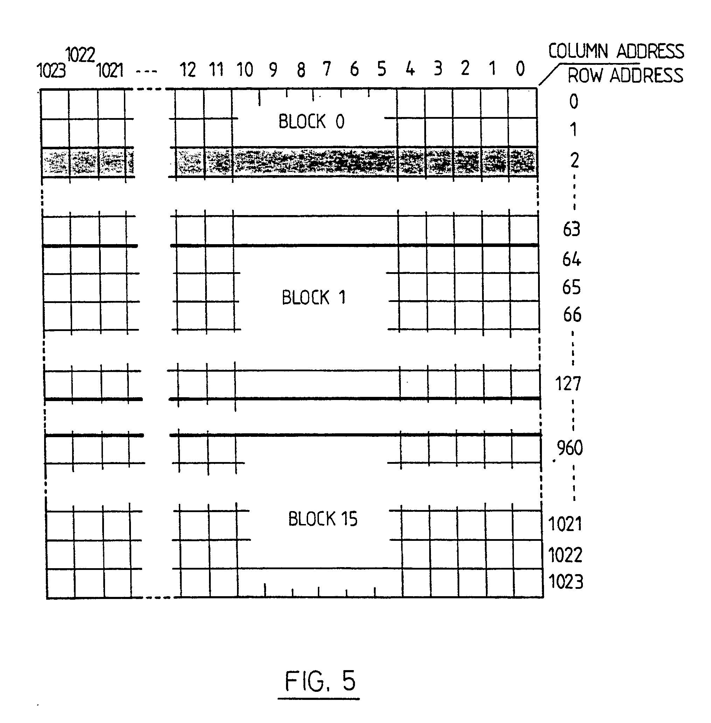

According to the invention, to maintain high usability of the memory even under such an address line failure, the address bits to be used as the row addresses are used as column addresses, while the address bits to be used as column addresses are used as row addresses. Fig 5 shows a memory map or distribution of locations, when the row address bits and the column address bits are interchanged. In this case, all locations related to the failure column 2 belong to the first block. Accordingly, by excluding only the first block (block 0) as an error block from those to be addressed, the remaining 15 blocks are made usable so that the usability of the memory can be maintained high, even though one of address lines is in failure.

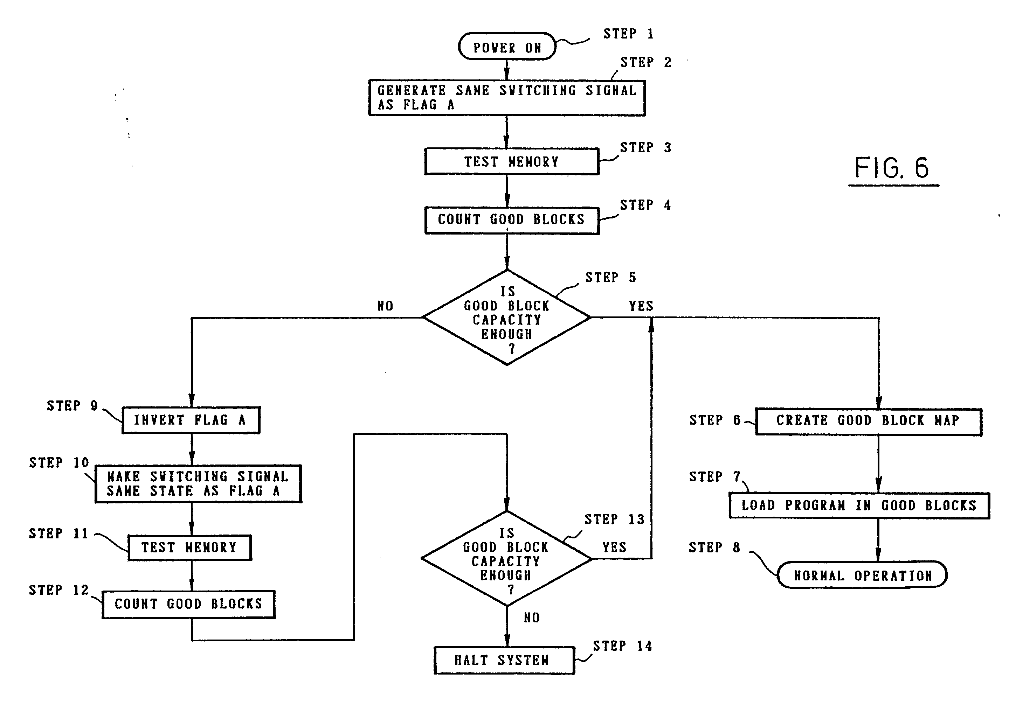

The operation of the embodiment of the invention will be described with reference to the operation flowchart of the controller shown in fig 6. According to the embodiment, in loading a predetermined amount of program in a memory which is subjected to block management, a test is made as to whether or not a region of memory is available having a large enough capacity to accommodate the program, so that the program may be loaded thereon, even if the memory has error locations. ·

In the controller 1, a nonvolatile memory for storing various parameters of the system is provided, with a flag A stored in a location in the memory. This flag A may take a value of 0 or 1 and is initially set to 0. As the memory system is started in step 1, that is, as the power is turned on, a switching signal representing the same state as that of flag A is generated on the control line 11 in step 2 and a test is conducted on the memory in step 3. In this test, the 20-bit address signals to each of all locations in the memory 2 are successively fed through the address line 3 and at the same time, fed to the memory 2 through the predetermined reference data bus 10. At this time, at each address, the selection signal on the control line 5 changes from 1 to 0; then, as this signal is given to the multiplexor 4 through the XOR circuit 6, the ten bits corresponding to the upper order addresses of respective address signals are fed to a row address line driver 8 through the address decoder 7, while the ten bits corresponding the lower order addresses are fed to the column address line driver 9. Reference data are stored at the locations corresponding to the address bits which are fed in this way, and the error locations are identified by successively reading the stored data to check them. The blocks which are found to contain error locations are excluded as error blocks from those to be addressed. Then, in step 4, the number of good blocks containing no error locations are counted. If the capacity of this good block is judged to be sufficient to accommodate the predetermined program in step 5, a good block map is created in step 6, whereby the usable blocks are identified. Then, the program is loaded in the good blocks in step 7, followed by normal operation in step 8.

If the capacity of the favourable blocks is judged to be insufficient to store the system program in the aforementioned step 5, the flag A is inverted in step 9. Then, in step 10, the switching signal is brought to the value 1 representing the state of the flag A or ON. Accordingly, in the test of step 11, the output from the XOR circuit 6 which is fed to the multiplexor 4 for each address changes from 0 to 1; as a result, the upper order address bits of the address signals are fed to the column address line driver 9 through the decoder 7, while the lower order address bits are fed to the row address line driver 8. Accordingly, the distribution of the memory addresses and the memory blocks are arranged as shown in Fig. 5. Then, in step 12, the number of good blocks are counted and in step 13, a test is made as to whether or not the capacity of the good blocks is sufficient to store the program. If this capacity is adequate, the process proceeds to the aforementioned step 6 to start normal operation via steps 7 and 8. Since the switching signal on the control line 11 is ON at the time of normal operation, the distribution of memory addresses in Fig. 5 is obtained. If the capacity of the good blocks is insufficient to store the program in the aforementioned step 13, the system stops the process because of memory errors in step 12.

There has been described a memory system comprising means for generating an address switching signal if, in a memory test conducted at the system starting time on the basis of the row and column address signals which are generated by a multiplexor, the capacity of blocks involving no error is detected to be smaller than a predetermined capacity necessary for storing information. The memory system further comprises means responsive to the address switching signal for controlling the multiplexor in such a way that it generates address signals which have the row and column address signals interchanged.

## Claims

1. A memory system comprising a memory having a plurality of locations, each of said locations being addressable by a row address signal and a column address signal, control means for managing access permission to a plurality of blocks within the memory, each block consisting of a plurality of the locations, the control means testing each location of the memory to identify blocks containing no error locations and to determine whether the capacity of the blocks containing no error locations is smaller than a predetermined capacity, means for interchanging the row address signal and the column address signal in response to determination of the capacity of the blocks containing no error locations being smaller than the predetermined capacity.

2. A memory system as claimed in claim 1 comprising a multiplexor for generating address signals each comprising a row address signal and a column address signal, the control means testing each location based on the address signals generated by the multiplexor; and wherein the means for interchanging the row address signal and the column address signal comprises means responsive to the control means for generating an address switching signal when the capacity of blocks having no error is smaller than the predetermined capacity; and means responsive to the address switching signal for controlling the multiplexor to generate address signals having the row address signals and the column address signals interchanged.

3. A memory system as claimed in claim 1 or claim 2 wherein the testing takes place at the start-up time of the memory system.

FIG. 1

A (LOWER ADDRESS)

B (UPPER ADDRESS)

3

AND

AND

OR

OUTPUT

13

INV

12

| CONTROL LINE 12 | OUTPUT |
|---|---|
| 1 | B |
| 0 | A |

MULTIPLEXER 4

FIG. 2

13

SELECTION SIGNAL

5

INV

AND

AND

ROW ADDRESS (10 BIT)

COLUMN ADDRESS (10 BIT)

OUTPUT

| SELECTION SIGNAL | OUTPUT |
|---|---|
| 1 | ROW ADDRESS |
| 0 | COLUMN ADDRESS |

ADDRESS DECODER 7

FIG. 3

FIG. 4

FIG. 5

FIG. 6

STEP 1 — POWER ON

STEP 2 — GENERATE SAME SWITCHING SIGNAL AS FLAG A

STEP 3 — TEST MEMORY

STEP 4 — COUNT GOOD BLOCKS

STEP 5 — IS GOOD BLOCK CAPACITY ENOUGH ?

NO / YES

STEP 9 — INVERT FLAG A

STEP 10 — MAKE SWITCHING SIGNAL SAME STATE AS FLAG A

STEP 11 — TEST MEMORY

STEP 12 — COUNT GOOD BLOCKS

STEP 13 — IS GOOD BLOCK CAPACITY ENOUGH ?

YES / NO

STEP 14 — HALT SYSTEM

STEP 6 — CREATE GOOD BLOCK MAP

STEP 7 — LOAD PROGRAM IN GOOD BLOCKS

STEP 8 — NORMAL OPERATION

EP 0 398 521 A2